# EUROPEAN PATENT APPLICATION

(11) **EP 4 585 557 A1**
(43) Date of publication of application: **16.07.2025**
(21) Application number: 24151669.9
(22) Date of filing: 12.01.2024
(51) Int. Cl.: B81C 1/00

(54) **METHOD AND APPARATUS OF FABRICATING NANOSTRUCTURED SILICON**

(71) Applicant: Fraunhofer-Gesellschaft zur Förderung der angewandten Forschung e.V., 80686 München (DE)
(72) Inventor: SITTINGER, Volker, 38108 Braunschweig (DE); HÖFER, Markus, 38108 Braunschweig (DE); KING, Hunter, 38108 Braunschweig (DE); HARIG, Tino, 38108 Braunschweig (DE)
(74) Representative: Stöckeler, Ferdinand

(57) **Abstract**

A method of fabricating nanostructured silicon on a substrate comprises a step of conducting a catalytic chemical vapor deposition using a Si-containing precursor and a carrier gas to generate on the substrate a silicon layer comprising columnar polycrystalline silicon structures and amorphous silicon containing material therebetween. The method further comprises conducting an anisotropic etching process of the silicon layer to remove the silicon between the polycrystalline silicon columns in order to fabricate the nanostructured silicon on the substrate.

## Description

The present application relates to a method of fabricating silicon layers having large surface structures and, in particular, nanostructured silicon on a substrate and an apparatus to perform such a method. Nanostructured silicon is also known under the terms "black silicon" or "silicon grass" and has columnar or needle-shaped silicon structures protruding from a substrate. The smaller the diameters of the columnar structures and the smaller the distance between them, the larger the surface area of the nanostructured silicon can be. So-called "black silicon" has its name due to the high absorption of light in the visible spectral range due to a high concentration of silicon grass with a high aspect ratio, which substantially reduces the reflection of the silicon material.

So far, silicon nanostructures are generated using either bottom-up approaches (VLS, vapor-liquid-solid), metal supported chemical etching (MACE), or by lithography in combination with anisotropic etching methods. With respect to such common approaches, reference is made to Ray U. et. al., "Silicon nanowires as an efficient material for hydrogen evolution through catalysis: A review", Catalysis Today 423, 2023, pages 4-6; Muduli R.C. et al: "Silicon nanostructures for solid-state hydrogen storage: A review", International Journal of Hydrogen Energy 48, 2023, pages 1410-1412; Richter K. et al: "Micro-Patterned Silicon Surfaces for Biomedical Devices", Plasma Processes and Polymers 2007, 4, pages 411 to 415; Srivastava S.K. et al: "Large area fabrication of vertical silicon nanowire arrays by silver-assisted single-step chemical etching and their formation kinetics", Nanotechnology 25 (2014), pages 2-3; and US 2022/0293427 A1.

Methods for forming deep structures having vertical edges in silicon are described in US 5,501,893 A and US 6,531,068 B2. Either a silicon wafer or a deposited silicon layer (such as generated by a chemical vapor deposition method) is provided with a photolithographic protective layer. Initially, a mask is created to be in a position to selectively protect and selectively etch, respectively, parts of a film or a substrate. Then, the film or substrate is anisotropically etched using a cyclic etching/polymerization method. In this method, an etching step and a polymerization step are alternatingly repeated. Material which is not protected, either by the local masking or by the secondary polymerization step, is removed by the etching step. In the polymerization step, a polymerization process is carried out to protect the sidewall created during the etching process. This helps to significantly reduce under-etching and improve the aspect ratio of the etching recesses. These two steps are repeated until the desired etching depth is achieved.

Bottom-up VLS approaches are generally less consistent/reproducible when performed with column diameters of less than a few micrometers and require deposition of catalytic metal particles prior to the growth step. Metal assisted chemical etch processes can be used to produce structures having high aspect ratios and a high structure density, but in addition to the deposition of a silicon layer, these methods require a second deposition step for the metal mask layer.

Different methods are known to deposit silicon layers on a substrate, such as PVD (physical vapor deposition), CVD (chemical vapor deposition) and PECVD (plasma-enhanced chemical vapor deposition). In commercial environments, processes using plasma-enhanced chemical vapor deposition, PECVD, or using conventional hot or cold wall chemical vapor deposition, CVD, are most commonly used. Chemical vapor deposition is characterized by a silicon-containing gaseous precursor species (e.g. silane) which is broken down into depositable species by application of energy. For example, silane, SiH₄ breaks down into both, atomic silicon and lower SiHₓ species, which can then be deposited on a substrate. In conventional CVD a thermal energy source is used and precursor gas is pumped into a reaction chamber and is decomposed at a heated wall of the chamber in case of a hot wall reactor or a heated substrate in case of a cold wall reactor. In PECVD, this energy source comes from a plasma source within the deposition chamber. Thermal CVD can be used to produce crystalline silicon materials with exceptionally low defect density for use in the semiconductor industry. However, with PECVD substantially higher deposition rates can be achieved and the decomposition of the starting materials is decoupled from the substrate temperature.

Another proven process for the production of silicon layers is hot-wire chemical vapor deposition, HWCVD, which is often called catalytic chemical vapor deposition, Cat-CVD, as well. In HWCVD, source gas molecules are decomposed by a catalytic cracking reaction with a heated catalyzer. Generally, the heated catalyzer is in the form of a filament, such as a coiled filament in order to increase the surface of the catalyzer. Various kinds of films have been deposited using HWCVD, such as films of amorphous silicon, a-Si, films of poly-crystalline silicon, poly-Si, and films of SiNₓ. In a HWCVD apparatus, a catalyzing wire is placed between a substrate holder and components for gas introduction, such as a gas showerhead. Source gas for the HWCVD include a central process gas and a secondary carrier and reactive gas. Generally, to deposit silicon, silane may be used as central process gas and hydrogen may be used as secondary carrier gas and reactive gas. In PECVD, a significant portion of the deposition species are lost to a counter electrode in the deposition chamber, in comparison, HWCVD processes do not suffer from this issue (due to a lack of a substrate bias/counter electrode), and therefore can achieve significantly higher deposition efficiencies (the conversion of precursor gas to film deposited onto substrate). Fundamentals of HWCVD (also called Cat-CVD or CLT-CVD) can be found in Hideki Matsumura et al, "Cat-CVD (Catalytic-CVD); Its Fundamentals and Application", ECS Transactions 25 (8), 2009, pages 53-63.

A catalytic CVD method for producing hydrogenated amorphous silicon is described by Hideki Matsumura, "Catalytic Chemical Vapor Deposition (CTL-CVD) Method Producing High Quality Hydrogenated Amorphous Silicon", Japanese Journal of Applied Physics, Vol. 25, No. 12, December 1986, pages L949-L951. Methods for producing polycrystalline silicon films using HWCVP are disclosed by J. Cifre et al, "Polycrystalline silicon films obtained by hot-wire chemical vapour deposition", Applied Physics A 59, 1994, pages 645-651. Details on HWCVP can also be found in R.E.I. Schropp "Industrialization of Hot Wire Chemical Vapor Deposition for thin film applications", Thin Solid Films 595, 2015, pages 272-283.

Hideki Matsumura, "Formation of Silicon-Based Thin Films Prepared by Catalytic Chemical Vapor Deposition (Cat-CVD) Method", Japanese Journal of Applied Physics, Vol. 37, 1998, pages 3175-3187, discloses a review of catalytic chemical vapor deposition methods and properties of silicon-based thin films, such as a-Si, poly-Si, and silicon nitride films, prepared by the Cat-CVD method. As far poly-Si films are concerned, this article discloses that in depositing the poly-Si film, at first poly-Si grains grow columnarly from the substrate directly, wherein the grains appear to be surrounded by a-Si layers of one to two nanometer thickness.

### Summary of the Invention

It is the object underlying the invention to provide a method and an apparatus of fabricating nanostructured silicon having a high aspect ratio in a simple manner.

This object is achieved by a method according to claim 1 and an apparatus according to claim 13. Further developments of the invention are defined by the dependent claims.

The invention provides for a method of fabricating nanostructured silicon on a substrate, comprising:
conducting a catalytic chemical vapor deposition using a Si-containing precursor and a carrier gas to generate on the substrate a silicon layer comprising columnar polycrystalline silicon structures and amorphous silicon containing material therebetween;
conducting an anisotropic etching process of the silicon layer to remove the silicon (the amorphous silicon containing material) between the polycrystalline silicon columns in order to fabricate the nanostructured silicon on the substrate.

The invention is based on the recognition that it is possible to etch a silicon layer comprising columnar polycrystalline silicon structures and amorphous silicon containing material therebetween in such a manner that the polycrystalline silicon, poly-Si, structures remain in place while the amorphous silicon containing material is removed. In particular, this may be achieved using an anisotropic etching process. Thus, nanostructured silicon, also called "black silicon" or "silicon grass", having a high aspect ratio may be produced in a simple manner. In addition, it was recognized that the nanostructured silicon fabricated in this manner may have a porosity which substantially enlarges the surface area of the silicon. Thus, the inventive method is particularly suited to generate silicon structures for applications in which a large surface area of the silicon structures is desired.

In embodiments, the anisotropic etching process is a dry ion etching process, which is effective as it permits using the same process chamber to carry out both, the catalytic chemical vapor deposition and the dry ion etching process.

In embodiments, the dry ion etching process comprises alternatingly repeating an etching step and a polymerizing step, wherein the etching step comprises anisotropic plasma etching to remove amorphous silicon containing material, and the polymerizing step comprises forming a polymer layer on polycrystalline silicon surfaces exposed in a preceding etching step, wherein the polymer layer is at least partially removed during an immediately following etching step. Thus, embodiments permit etching the a-Si while etching the poly-Si is avoided in a reliable manner. To be more specific, in the polymerization step, a polymerization process is carried out to protect the sidewall created during the etching process. This helps to significantly reduce under-etching and improve the aspect ratio of the etching recesses. These two steps are repeated until the desired etching depth is achieved. Thus, the nanostructured silicon having a high aspect ratio may be fabricated in reliable manner.

In embodiments, the anisotropic etching process is selective in that it has a higher etching rate for the amorphous silicon containing material when compared to polycrystalline silicon. Thus, the amorphous silicon containing material is etched faster than the columnar polycrystalline silicon structures and the amorphous silicon containing material may be removed while at least parts of the columnar polycrystalline silicon structure forming the nanostructured silicon remain.

It was further recognized that the anisotropic etching process, such as the dry ion etching process above, may be conducted without using an etch mask. Thus, fabrication of the nanostructured silicon can be simplified when compared to common CVD or PECVD processes requiring a lithographical masking process.

In embodiments, the carrier gas is H₂ and the Si-containing precursor is SiH₄. Thus, embodiments permit the silicon layer comprising columnar poly-Si and a-Si therebetween using established HWCVD deposition processes.

In embodiments, the catalytic chemical vapor deposition is conducted using a catalyzer temperature ≥ 1800°C, a substrate temperature ≤ 600°C and a flow ratio between the carrier gas and the Si-containing precursor of above 6:1. In embodiments, the flow ratio between the carrier gas and the Si-containing precursor and a pressure used in the catalytic chemical vapor deposition are adapted to obtain a partial pressure ratio between the carrier gas and the Si-containing precursor of 20:1 to 100:1 or above. It was recognized that using such process parameters columnar poly-Si structures having a high aspect ratio and surrounded by a-Si can be produced in a reproducible manner.

In embodiments, phosphine, PH₃, or diborane, B₂H₆, is used as dopant gas during the catalytic chemical vapor deposition. Thus, embodiments permit for the fabrication of doped nanostructured silicon and, therefore, permit the nanostructured silicon to be adapted to different applications.

In embodiments, the thickness of the generated silicon layer is between 0,1 and 100 µm, in particular between 10 µm and 100 µm. Generating the silicon layer with such a thickness permits the fabrication of columnar poly-Si structures having a high aspect ratio in view of the fact that the columnar poly-Si structures may reach diameters up to less than 50 nm. In embodiments, a distance between at least some columns in the generated nanostructured silicon is ≤ 50 nm. Embodiments of the invention permit the fabrication of nanostructured silicon with such dimensions without the necessity of masking processes and, therefore, in a simple manner.

### Brief Description of the Drawings

Embodiments of the present invention will be detailed subsequently referring to the appended drawings, in which:
Fig. 1 shows a flow chart illustrating an embodiment of the inventive method;
Fig. 2 shows a flow chart illustrating an embodiment of an etching process used in an embodiment of the inventive method;
Fig. 3 shows a REM picture showing a cross section of a silicon layer formed by a deposition process used in an embodiment of the inventive method;
Fig. 4 shows a REM picture of nanostructured silicon formed by an embodiment of the inventive method;
Fig. 5 shows a more enlarged REM picture of a nanostructured silicon formed by an embodiment of the inventive method;
Fig. 6 shows an example of Si film stress versus H₂ flow rate achieved in generating the silicon layer/film on the substrate using HWCVD; and
Fig. 7 shows a schematic view of a plant according to an embodiment of the invention.

### Detailed Description of the Invention

Examples of the present invention will be described in detail below, using the accompanying drawings. It should be noted that identical elements or elements having the same functionality can be provided with the same or similar reference numbers, and a repeated description of elements provided with the same or similar reference numbers is typically omitted. Descriptions of elements having the same or similar reference numbers are interchangeable. In the following description, many details are described to provide a more thorough explanation of examples of the invention. However, it will be apparent to those skilled in the art that other examples can be implemented without these specific details. Features of the various examples described can be combined with each other unless features of a corresponding combination are mutually exclusive or such a combination is explicitly excluded.

The present invention relates to the production of nanostructured silicon, in which a silicon layer is deposited on, for example, a silicon wafer as a substrate, in such a way that the nanostructure may be formed in a subsequent etching process without the time-consuming process of additional masking or lithography steps. In addition, the density and aspect ratio of the resulting nanostructures are higher than with other existing products. The silicon layer can be deposited on various substrates such as glass, ceramics, silicon, metals and others. An undercoating, adhesive layer, may be formed on the substrate before the silicon layer comprising the columnar polysilicon structures is deposited. Embodiments of the invention provide a method to fabricate an easy-to-produce nanostructure in silicon by depositing a silicon layer, for the production of which process parameters may be used to form the silicon layer comprising the combination of polycrystalline silicon and amorphous silicon containing material, which is then etched to achieve the nanostructured silicon.

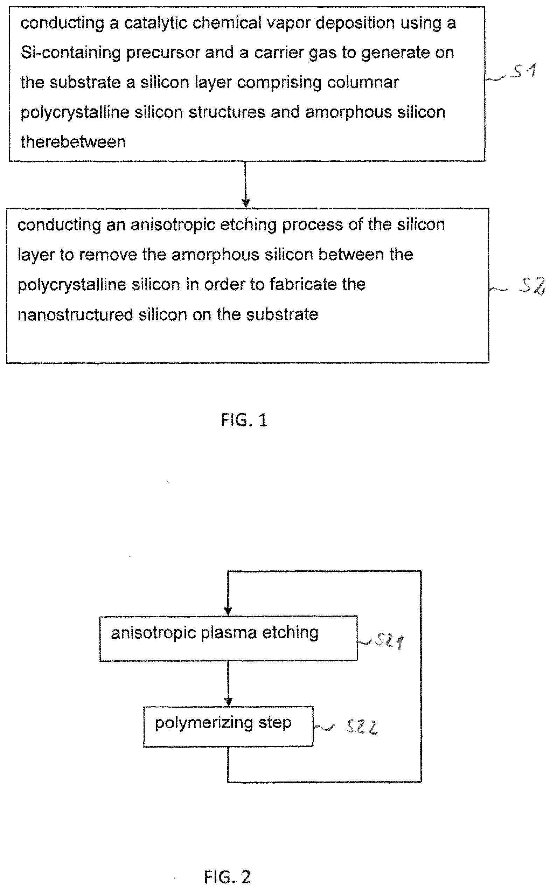

Fig. 1 shows an embodiment of the inventive method for fabricating nanostructured silicon. The method comprises a step S1 of conducting a catalytic chemical vapor deposition using a Si-containing precursor and a carrier gas to generate on the substrate a silicon layer comprising columnar polycrystalline silicon structures and amorphous silicon containing material therebetween. The method further comprises a step S2 of conducting an anisotropic etching process of the silicon layer to remove the amorphous silicon containing material between the polycrystalline silicon in order to fabricate the nanostructured silicon on the substrate.

According to the inventive approach, a catalytic chemical vapor deposition, Cat-CVD, is used to deposit the silicon layer. Generally, the catalyzer used in Cat-CVD is a wire or filament and, therefore, Cat-CVD is often referred to as hot wire chemical vapor deposition, HWCVD. In embodiments of the invention, the catalyzer is formed by one or more wires or filaments, preferably coiled filaments. In other embodiments, the catalyzer may have a different form. The terms Cat-CVD and HWCVD are used exchangeable herein.

HWCVD permits the deposition of silicon layers having columnar poly-Si structures and a-Si between the columnar poly-Si structures. HWCVD can deliver significantly higher deposition rates than thermal CVD and, therefore, permits a faster fabrication when compared to CVD. In addition, HWCVD allows the deposition of the precursors to be decoupled from the substrate temperature. HWCVD has relatively low power density for the decomposition of the species compared to PECVD and, therefore, silicon layers deposited by HWCVD can have lower densities and an increased incorporation of defects and impurities into the layer. However, HWCVD layers are beneficial compared to PECVD layers since exceptionally low layer stresses are possible, such as below 20 MPa.

The term "nanostructured" as used herein is intended to refer to structures having dimensions in the nanometer region, i.e., below one µm, and the term nanostructured silicon is intended to encompass structures which are commonly known as black silicon or silicon grass.

The amorphous silicon containing material may be pure amorphous silicon or may be mixed structure silicon including amorphous silicon and additional constituents, such as portions of poly-Si. In examples, the portions of poly-Si may have other crystallographic orientations than the columns. Other crystallographic orientations than the columns may lead to faster etch rates as these rates are also often crystallographic orientation dependent.

Thus, embodiments of the invention relate to a method for producing mixed amorphous/nanocrystalline silicon layers, which may be either intrinsically or n-type or p-type doped. The key advantage of this method over other technologies may be twofold. Firstly, the mixed phase material may be automatically etched preferentially into high aspect ratio structures without the need for a lithographic masking process. Secondly, the resulting structures may be thinner and more densely packed than those produced by other methods.

In embodiments of the invention, step S1 comprises the production of silicon layer by chemical vapour deposition by means of a hot wire using silane (SiH₄) as the central process gas, hydrogen (H₂) as the secondary carrier gas and reactive gas. In addition, in embodiments, phosphine (PH₃) and/or diborane (B₂H₆) are used as doping gases for the production of layer thicknesses between 0.1 and 500 µm. In embodiments, PH₃ is used as a doping gas for doping (0.1 vol. % to 1.0 vol. % relative to the SiH₄ in the deposition process) in step S1, which turned out to be effective to support formation of the silicon layer having the columnar poly-Si structures with the a-Si therebetween.

In embodiments of the invention, step S1 comprises of a coating process, in which silane is decomposed on hot wires at high temperatures of greater than 1800 °C while the substrate temperature is less than 600 °C, and in which an amorphous/nanocrystalline structure is formed. The term nanocrystalline is intended to refer to a polycrystalline structure having dimensions in the nanometer region at least in one direction thereof.

In embodiments, the coating process of step S1 comprises a high dilution of the silane gas in the hydrogen gas as carrier gas, with the dilution ranging from 20:1 to over 100:1 of H₂: SiH₄.

In embodiments, step S1 comprises a partial pressure ratio of the central process gas, i.e., the Si-containing precursor, such as SiH₄, to the carrier gas, such as H₂, at the substrate in a range of about 20:1 to 100:1. In embodiments, such a partial pressure ratio is achieved by adjusting the dilution of the central process gas in the carrier gas and/or by reducing a vacuum pumping rate, i.e., increasing the process pressure. The pumping rate is referring to the pumping rate of the pumps which are used to draw a vacuum on the process chamber. For example, reducing the rate at which the pump evacuates the process chamber, while retaining the inlet gas flow rate, would lead to an increase in the steady-state process pressure.

In embodiments, the silicon layer generated in step S1 has low residual compressive stresses of less than 200 MPa, or preferably less than 20 MPa, and is either intrinsic or n-type or p-type doped.

In embodiments, during the deposition in step S1, a silicon layer with a mixed crystallinity (crystalline, amorphous) is produced which has a columnar structure, whereby highly crystalline columns with a structure of amorphous silicon containing material in between are produced. SiO₂ may also be produced at the crystallite boundaries as these also have a lower density compared to PECVD and CVD deposited densities which in turn promotes silicon oxide formation upon exposing the layers to oxygen (such as layer exposure to air after the deposition process).

In embodiments, step S2 comprises a dry ion etching process to create the silicon nanostructure after fabrication of the silicon layer without the use of masking or lithography steps. In embodiments, columnar etched structures, which may be referred to as columns, with a very high aspect ratio are generated in step S2. The columns may reach diameters up to less than 50 nm. Distances between columns may be ≤ 50 nm. In embodiments, the columnar structures etched in step S2 have a substructure in the form of a nanoporosity, which significantly increases the surface area of the fabricated nanostructured silicon.

Fig. 2 shows an embodiment of step S2, in which the anisotropic etching process is a dry ion etching process comprising two substeps S21 and S22, which are alternatingly repeated. Substep S21 is an anisotropic plasma etching step and substep S22 is a protective polymerization step.

In substep S21, the amorphous silicon containing material is removed. During substep S21, parts of the polycrystalline columnar structures may also be removed. In substep S22, a polymer layer is formed on polycrystalline silicon surfaces exposed in a preceding etching step. In substep S22, a polymer layer may also be formed on exposed parts of the amorphous silicon containing material. Substeps S21 and S22 are alternatingly repeated in such a manner that the amorphous silicon containing material, or at least substantial portions thereof, is removed between the columnar polycrystalline structures and at least parts of the columnar polycrystalline structures forming the nanostructured silicon remain in place protruding from the substrate. The inventors recognized that step S2 may take place without making use of an etching mask to produce selectively etched wells. Rather, the etch phase in substep S21 preferentially etches the material between the columnar polycrystalline silicon material, i.e., the etching is selective in that the etching rate with respect to the a-Si is higher than that with respect to the poly-Si. SiO₂ barriers formed at the crystallite boundaries may support the formation of the nanostructured silicon during the etch process. As the etching process continues, the polymerization steps will help to protect the grass-like structures and continue to etch the more easily etchable amorphous silicon containing material which exists between the polycrystalline columnar structures.

In embodiments of the invention, a silicon substrate is used as the initial substrate. In other embodiments, the substrate may comprise other materials, such as glass, ceramics, silicon, metals or polymer. The substrate may comprise a coating layer acting as an adhesive layer for the deposition in step S1. Such a coating layer may be deposited prior to step S1 using HWCVD or by any other method. Depositing the coating layer using HWCVD permits the coating layer to be deposited in the same process chamber in which step S1 is performed.

In an embodiment of the invention, the following parameters are used in step S1:
- wire temperature between 1800°C and 2300°C.
- substrate temperature below about 550°C and above 350°C (preferably at 400° ± 10%). It was recognized that below the lower limit there may be problems with the film adhesion/growth, and above about 600°C the columnar structure may be lost.
- silane (SiH₄) as the central process gas and hydrogen (H₂) as the carrier gas, and optionally phosphine (PH₃) or diborane (B₂H₆) as doping gas
- total working pressures 4Pa and above, such a between 4Pa and 20Pa
- H₂:SiH₄ flow ratio above 6:1, preferably between 13:1 and 350:1.

In alternative embodiments, other Si-containing precursors may be used, such as S₂H₆, H₂SiCl₂, SiCl₄, HCL₃Si.

In embodiments of the invention, the catalyzer comprises tungsten, W. In other embodiments, other materials suitable to perform HWCVD at corresponding temperatures may be used, such as Ta.

In the following, a specific detailed embodiment for fabricating nanostructured silicon on a substrate is described. The detailed embodiment was implemented using an 8" wafer as the substrate or using a copper foil as a substrate. A number of filaments formed of tungsten were used as the catalyzer. Filament current is the current through the filaments in order to heat the same to the filament temperature. Pressure is the pressure in the process chamber.

In a first step, a coating layer is formed on the substrate. If the substrate is a silicon substrate this step may be omitted. The coating layer is formed using the following parameters:

| a-Si - intermediate layer for providing adhesion (may also be formed of SiO₂ or Si₃N₄) - dynamic coating (150 mm/s) | | | | | | | |
|---|---|---|---|---|---|---|---|
| target layer thickness | filament diameter | number of filaments | filament current | filament temperature | gas flow SiH₄ [sccm] | pressure | deposition time |
| 1 nm | 0.25 mm | 10 | 43 A | 1900°C | 100 | 1 Pa | 3 |

Depositing the intermediate layer was carried out dynamically with a speed of 150 mm/s, that is, a carrier containing the substrate was driven in parallel to the wire array at a carrier speed of 150 mm/s for a single pass. This single pass with the deposition parameters for the intermediate layer resulted in a ~1 nm thick intermediate layer (the deposition time refers to the time it took the carrier to fully pass in front of the wires at the carrier speed of 150 mm/s).

In alternative embodiments, the intermediate layer could have a lower thickness.

In a second step of the specific detailed embodiment, the silicon layer comprising the columnar poly-Si and the a-Si is formed using the following process parameters.

| | | |
|---|---|---|
| target layer thickness [nm] | 10000 | |
| filament diameter [mm] | 0.53 | |
| number of filaments | 10 | |
| filament current [A] | 155 | |
| filament temperature [°C] | 2100 | |
| flow of SiH₄ [sccm] | 90 | |
| flow of H₂ [sccm] | 5050 | |
| flow of phosphine [sccm] | 10 | 10% phosphine in silane |
| pressure [Pa] | 17.2 | |
| heater temperature of the module [°C] | 450 | |
| deposition time [s] | 10000 | |

The heater temperature of the module is the temperature of the holder on which the substrate is placed so that this temperature may be regarded as corresponding to the substrate temperature or as being somehow higher than the substrate temperature.

The deposition in this second step is static.

In a third step of the specific detailed embodiment, the anisotropic etching process is performed. In this step, an etching process as described above referring to Fig. 2 is performed using SF₆ as etching gas and C₄F₈ as polymerization gas. Etching was performed using a standard ICP etching plant and using the following parameters.

| | | gas | Power ICP |
|---|---|---|---|
| total etching time | 3 min | | |
| polymerization gas | | C₄F₈, 200 sccm | 1800 W |
| etching gas | | SF₆, 270 sccm | 2500 W |
| HF stimulation substrate | 380 KHz | | 55 W |

The total etching time for an etching depth of 10 µm was 3 min. The etching step and polymerization step alternate in the range of seconds. In principle, the substrate bias, i.e., the stimulation of the substrate, can also take place at higher frequencies, e.g. RF.

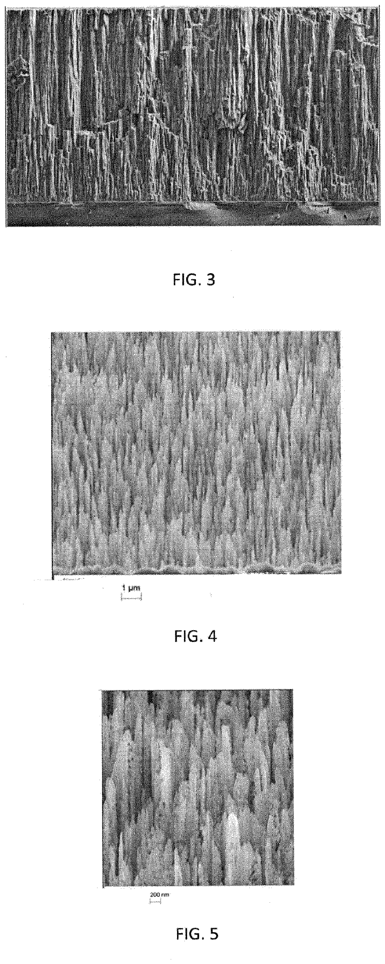

A REM (raster or scanning electron microscope) picture showing a cross section of a silicon layer formed by a deposition process as described above is shown in Fig. 3. The columnar shape of the poly-Si structures can be understood from Fig. 3, wherein, in principle, the columns may have nearly the same heights or may have slightly different heights. Fig. 3 shows the silicon layer before performing the etching process. The silicon layer shown in Fig. 3 has a total thickness of 120 µm. Figures 4 and 5 show REM pictures of nanostructured silicon after the etching step along with a scale giving an impression of the dimension of the columnar poly-Si structures formed. A five times larger scale is used in the picture in Fig. 5.

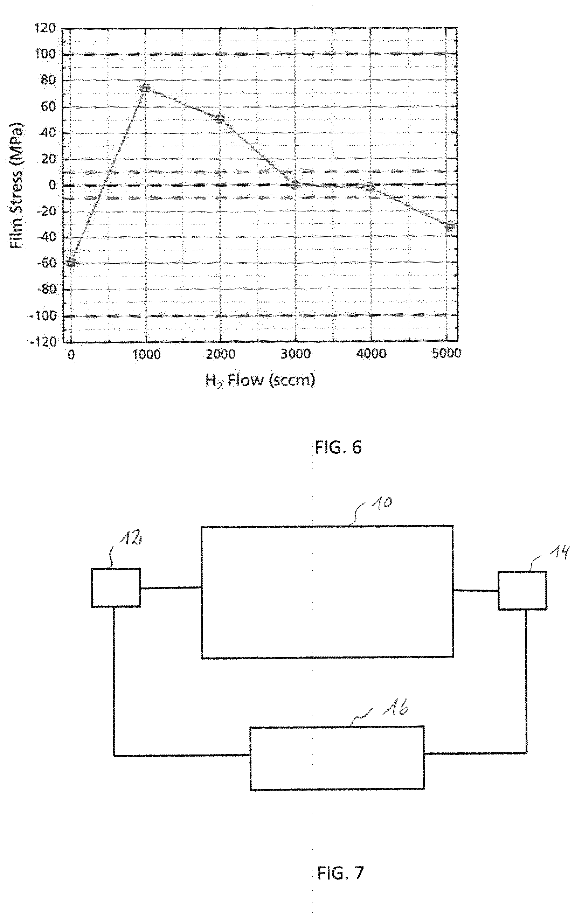

The HWCVD process used in the inventive method to generate the silicon layer on the substrate permits low achievable film stress in the silicon layer formed on the substrate and in the nanostructured silicon when compared with other deposition methods. Such lower film stresses are achievable due to a lack of ion bombardment/ high energy sources). An example of results of Si film stress versus H₂ flow rate which were achieved using an exemplary method described herein, is shown in Fig. 6. As it is shown, a film stress below 100 MPa is achieved over the whole range of H₂ flow rates shown in Fig. 6. In addition, an even lower film stress may be achieved by adapting the flow rate of H₂. In particular, adjusting the flow rate to be in a region of about 2800 sccm to about 4200 sccm resulted in a film stress of below 20 MPa.

As far as further details concerning parameters of a suitable etching process to be used in step S2 are concerned reference can be made to US 5,501,893 A and US 6, 531,068 B2, the teaching of which in this regard is incorporated herein by reference. It is to be emphasized that the inventors surprisingly recognized that the masking steps disclosed in these documents are not necessary in fabricating the nanostructured silicon according to embodiments of the invention.

As far as further details concerning parameters of a suitable deposition process of the silicon layer comprising columnar poly-Si structures and a-Si therebetween are concerned, reference can be made to Hideki Matsumura, "Formation of Silicon-Based Thin Films Prepared by Catalytic Chemical Vapor Deposition (Cat-CVD) Method", Japanese Journal of Applied Physics, vol. 37, 1998, pages 3175-3187, the corresponding teaching of which is incorporated herein by reference.

Although a specific anisotropic dry etching process is described in the above embodiments, other embodiments may be implemented using other anisotropic etching processes permitting the a-Si to be removed. For example anisotropic wet etching processes may be used, such as a TMAH process as described in US 8,999,850 B2. In preferred embodiments, a selective etching process is used so that usage of a separate etching mask can be avoided.

Embodiments of the present invention provide an apparatus for fabricating nanostructured silicon, which permits the method disclosed herein to be performed within the same process chamber. Such an apparatus may include usual features of common HWCVD plants such as a substrate holder, a catalyzer (e.g. one or several filaments), a heater for heating the substrate holder, a pump for generating a process pressure in the process chamber, etc. With respect to such additional features, reference is made to the documents cited herein, for example. Fig. 7 shows an example of an embodiment of a HWCVD apparatus. The apparatus is configured to fabricate nanostructured silicon on a substrate using a method as described herein. The apparatus comprises a common process chamber 10, in which the catalytic chemical vapor deposition and the anisotropic etching process are conducted. The apparatus comprises a first gas supply unit 12 configured to supply the Si-containing precursor and the carrier gas to the common process chamber 10. To this end, first gas supply unit 12 is coupled to the common process chamber 10 and may include gas sources and gas conduits coupled to a shower head configured to provide the process gas and the carrier gas from the gas sources into the common process chamber 10. The apparatus comprises a second gas supply unit 14 configured to supply an etching gas to the common process chamber. The second gas supply unit 14 is coupled to the common process chamber and may include a gas source and a gas conduit coupled to the or a shower head in order to provide the etching gas into the process chamber. In embodiments, the second gas supply unit 14 may be configured to supply an etching gas and a polymerization gas to the common process chamber 10 and may include a first gas source for the etching gas, a second gas source for the polymerization gas and gas conduits for providing these gases to the or a shower head. The apparatus comprises a controller 16 configured to control the first gas supply unit 12 to supply the Si-containing precursor and the carrier gas to the common process chamber 10 to conduct the catalytic chemical vapor deposition and to control the second gas supply unit 14 to supply the etching gas to the common process chamber 10 to conduct the anisotropic etching process. The controller 16 may be configured to control the second gas supply unit 14 to alternatingly supply the etching gas and the polymerization gas to the common process chamber 10 to perform the etching process in which etching steps and polymerization steps are alternatingly performed.

As is obvious to those skilled in the art, a controller may be implemented, for example, by one or more appropriately programmed computing device(s) or a user-specific integrated circuit(s). Generally, controller 16 may be implemented by hardware or software or a combination thereof.

Accordingly, embodiments of the present invention provide methods and apparatus for creating black silicon (also known as nanostructured silicon, silicon grass, etc.), that are very economical and permit large surface areas of the silicon structures. It is believed that the inventive approach may produce higher structure densities and heights than other methods. Embodiments of the invention remove the need for a masking step and utilize HWCVD (instead of traditionally thermal CVD, PECVD, or PVD) which is cheaper and has more effective precursor-film conversion rates.

Nanostructured silicon fabricated by the teachings herein may have a plurality of different applications, in particular such applications in which large surface areas of the silicon material are needed. For example, the material may be used as a physical scaffold for gas sensing materials. Sensing material may be deposited on the nanostructured silicon, which significantly increases the surface area of the sensing material. This improves both the response time and the lower sensing limit. Using this material as a scaffold allows for changing and tuning the gas sensing material for different applications without having to create a nanostructured version of that material directly. Another field of application may be the usage in batteries as a nanostructured electrode material, which can improve performance and allow for swelling of electrodes during operation without damage. The nanostructured silicon may be used in the field of photovoltaic, i.e., in the field of solar cells. Black silicon has been investigated for use in photovoltaic and optic applications due to the high aspect ratio structures significantly increasing the light trapping ability of silicon compared with planar (flat) samples. This can help to improve the efficiency of black silicon solar cells compared with traditional flat silicon cells.

Although some aspects of the present disclosure have been described as features related to an apparatus, it is obvious that such a description may also be considered as a description of corresponding method features. Although some aspects have been described as features related to a method, it is obvious that such a description may also be considered as a description of corresponding features of an apparatus or functionality of an apparatus.

The above disclosure provides illustrations and descriptions, but it is not intended that the same be exhaustive or that the implementations be limited to the precise form disclosed. Modifications and variations are possible with respect to the above disclosure or may be obtained from practice of the implementations. Although certain combinations of features are recited in the claims and/or disclosed in the description, it is not intended that these features limit the disclosure of possible implementations. In fact, numerous of these features may be combined in ways not specifically recited in the claims and/or disclosed in the description. Although each of the dependent claims recited below may depend directly on only one or some of the claims, the disclosure of possible implementations encompasses each dependent claim in combination with all other claims in the set of claims.

While this invention has been described in terms of several advantageous embodiments, there are alterations, permutations, and equivalents, which fall within the scope of this invention. It should also be noted that there are many alternative ways of implementing the methods and compositions of the present invention. It is therefore intended that the following appended claims be interpreted as including all such alterations, permutations, and equivalents as fall within the true scope of the present invention.

## Claims

1. A method of fabricating nanostructured silicon on a substrate, comprising:
conducting a catalytic chemical vapor deposition using a Si-containing precursor and a carrier gas to generate on the substrate a silicon layer comprising columnar polycrystalline silicon structures and amorphous silicon containing material therebetween;
conducting an anisotropic etching process of the silicon layer to remove the silicon between the polycrystalline silicon columns in order to fabricate the nanostructured silicon on the substrate.

2. The method of claim 1, wherein the anisotropic etching process is a dry ion etching process.

3. The method of claim 1 or 2, wherein the dry ion etching process comprises alternatingly repeating an etching step and a polymerizing step, wherein the etching step comprises anisotropic plasma etching to remove amorphous silicon containing material, and the polymerizing step comprises forming a polymer layer on polycrystalline silicon surfaces exposed in a preceding etching step, wherein the polymer layer is at least partially removed during an immediately following etching step.

4. The method of one of claims 1 to 3, wherein the anisotropic etching process is selective in that it has a higher etching rate for the amorphous silicon containing material when compared to polycrystalline silicon.

5. The method of one of claims 1 to 4, wherein the anisotropic etching process is conducted without using an etch mask.

6. The method of one of claims 1 to 5, wherein the carrier gas is H₂ and/or wherein the Si-containing precursor is SiH₄.

7. The method of one of claims 1 to 6, wherein the catalytic chemical vapor deposition is conducted using a catalyzer temperature ≥ 1800°C, a substrate temperature ≤ 600°C and a flow ratio between the carrier gas and the Si-containing precursor of above 6:1.

8. The method of claim 7, wherein the flow ratio between the carrier gas and the Si-containing precursor and a pressure used in the catalytic chemical vapor deposition are adapted to obtain a partial pressure ratio between the carrier gas and the Si-containing precursor of 20:1 to 100:1 or above.

9. The method of one of claims 1 to 8, wherein phosphine, PH₃, or diborane, B₂H₆, is used as dopant gas during the catalytic chemical vapor deposition.

10. The method of one of claims 1 to 9, wherein a thickness of the generated silicon layer is between 0,1 and 100 µm.

11. The method of one of claims 1 to 10, wherein a distance between at least some columns in the generated nanostructured silicon is ≤ 50 nm.

12. The method of one of claims 1 to 11, wherein a film stress in the generated silicon layer is less than 200 MPa, less than 100 MPa or, preferably, less than 20 MPa.

13. An apparatus for fabricating nanostructured silicon on a substrate using a method according to one of claims 1 to 12, comprising:
a common process chamber, in which the catalytic chemical vapor deposition and the anisotropic etching process are conducted;
a first gas supply unit configured to supply the Si-containing precursor and the carrier gas to the common process chamber;
a second gas supply unit configured to supply an etching gas to the common process chamber; and
a controller configured to control the first gas supply unit to supply the Si-containing precursor and the carrier gas to the common process chamber to conduct the catalytic chemical vapor deposition and to control the second gas supply unit to supply the etching gas to the common process chamber to conduct the anisotropic etching process.

14. The apparatus of claim 13, in which the second gas supply unit is configured to supply an etching gas and/or a polymerization gas to the common process chamber, wherein the controller is configured to control the second gas supply unit to alternatingly supply the etching gas and the polymerization gas to the common process chamber to perform the method of claim 3.
